# EUROPEAN PATENT APPLICATION

(11) **EP 4 365 583 A1**
(43) Date of publication of application: **08.05.2024**
(21) Application number: 22833129.4
(22) Date of filing: 28.06.2022
(51) Int. Cl.: G01N 27/26, G01N 27/00, G01N 27/30

(54) **DROPLET SENSOR, DEW CONDENSATION DETECTION DEVICE, AND METHOD FOR MANUFACTURING SAME**

(30) Priority: 30.06.2021 JP 2021108423
(71) Applicant: National Institute for Materials Science, Tsukuba-shi, Ibaraki 305-0047 (JP)
(72) Inventor: KAWAKITA Jin, Tsukuba-shi, Ibaraki 305-0047 (JP)
(74) Representative: Dehns
(86) International application number: PCT/JP2022/025639
(87) International publication number: WO 2023/276982

(57) **Abstract**

An object of the present invention is to provide a droplet sensor and a condensation detection device having stable detection properties and a method for manufacturing the same. Even when the droplet sensor and the condensation detection device are mass-produced, the present invention enables reduction of manufacturing variation between the elements and enables high detection accuracy and high electrical output of the elements. A droplet sensor of the present invention includes: an insulating substrate; a first electrode having a first thin wire and a first current collector; and a second electrode having a second thin wire and a second current collector. The first electrode and the second electrode are disposed on the insulating substrate. The first thin wire and the second thin wire are alternately disposed in juxtaposition with each other on the insulating substrate. The droplet sensor senses a galvanic current flowing between the first thin wire and the second thin wire through a conductive droplet. The first thin wire is formed of a first metal-containing material layer having a lower electrical resistivity than platinum. The second thin wire is a composite film of the first metal-containing material layer and a platinum-containing material composed of platinum or a platinum alloy. The platinum-containing material layer has at least a part of a surface exposed to the outside.

## Description

### Technical Field

The present invention relates to a droplet sensor and a condensation detection device, more particularly, a droplet sensor and a condensation detection device having high accuracy and high sensitivity in droplet detection and a method for manufacturing the same.

### Background Art

As a droplet sensor and a condensation detection device to which the droplet sensor is applied, there is known an element that senses a galvanic current flowing between two kinds of metals through a droplet (galvanic-type droplet sensor) as well as an element that measures changes in electrical resistance (impedance) and capacitance of a sensor element.

Particularly, the galvanic-type droplet sensor has many characteristics such as simple structure, compactness, and high droplet detection sensitivity. Furthermore, the galvanic drop sensor operates without necessarily requiring an external power supply.

The galvanic-type droplet sensor has a structure in which a large number of wires using two kinds of different metals are arranged at a small spacing and detects a conductive droplet by sensing a current flowing between the metal wires when the droplet touches the small spacing. Such a galvanic-type droplet sensor is disclosed in, for example, Patent Literature 1. In addition, Non-Patent Literature 1 proposes to coat gold of a cathode with platinum so as to increase electrical output in a galvanic-type droplet sensor which uses aluminum and gold as a combination of dissimilar metals.

Condensation on a surface of an object causes mold, rust, or scattering of light. For example, condensation on a wall encourages mold growth since mold acquires nutrients from contamination attached to the surface of the wall. Condensation on a metal causes rust due to corrosion. Condensation in a pantry reduces the tastes and quality of foods. Condensation in a pantry also tends to cause hygienic problems such as mold on foods. Condensation on a transparent member such as window glass causes fogging. Condensation on a lens due to a high humidity causes a scattering of light incident on the lens, which results in deterioration of imaging performance of the lens such as distortion of an image. When each water drop caused by the condensation has a small size, the water drops look like flare and reduce contrast in an image.

For these reasons, it is important to detect condensation with accuracy and high sensitivity, and there is high demand for a highly-accurate and highly-sensitive condensation detection device.

### Citation List

### Patent Literature

Patent Literature 1: WO 2016/13544 A1

### Non Patent Literature

Non Patent Literature 1: R. G. Shrestha, et al., ECS Transactions, 98 (11) 35-47 (2020)

### Summary of Invention

### Technical Problem

The inventor has manufactured a plurality of galvanic-type droplet sensors in the related art and condensation detection devices using the same and has found that detection accuracy varies between the sensors (elements) and that detection sensitivity of each sensor (a galvanic current (electrical output) sensed by each sensor) is not always sufficient.

An object of the present invention is to solve these problems in the related art and to provide a droplet sensor and a condensation detection device having stable detection properties and a method for manufacturing the same. Even when the droplet sensor and the condensation detection device are mass-produced, the present invention enables reduction of manufacturing variation (variation attributed to manufacturing processes) between droplet sensors and between condensation detection devices and enables high detection accuracy and high electrical output of the droplet sensors and the condensation detection devices.

### Solution to Problem

Configurations of the present invention will now be described.

### (Configuration 1)

A droplet sensor comprising:
an insulating substrate;
a first electrode having a first thin wire and a first current collector; and
a second electrode having a second thin wire and a second current collector,
the first electrode and the second electrode being disposed on the insulating substrate, and the first thin wire and the second thin wire being alternately disposed in juxtaposition with each other on the insulating substrate, and
the droplet sensor being configured to sense a galvanic current flowing between the first thin wire and the second thin wire through a conductive droplet, in which
the first thin wire and the first current collector are formed of a first metal-containing material layer having a lower electrical resistivity than platinum,
the second thin wire is a composite film of the first metal-containing material layer and a platinum-containing material layer composed of platinum or a platinum alloy, and the second current collector includes the first metal-containing material layer, and
the platinum-containing material layer has at least a part of a surface exposed to the outside.

### (Configuration 2)

The droplet sensor according to the configuration 1, in which the second thin wire is a laminated film of the first metal-containing material layer and the platinum-containing material layer.

### (Configuration 3)

The droplet sensor according to configuration 1, in which the second thin wire has a core formed of the first metal-containing material layer, and the platinum-containing material layer is formed at least on a part of a sidewall of the core.

### (Configuration 4)

The droplet sensor according to the configuration 1, in which the second thin wire has a core formed of the first metal-containing material layer, and the platinum-containing material layer is formed to cover the core.

### (Configuration 5)

The droplet sensor according to any one of the configurations 1 to 4, in which the spacing between the first thin wire and the second thin wire is constant.

### (Configuration 6)

The droplet sensor according to any one of the configurations 1 to 5, in which the first metal-containing material layer is composed of one or more metals selected from the group consisting of aluminum (Al), magnesium (Mg), zinc (Zn), iron (Fe), cobalt (Co), nickel (Ni), molybdenum (Mo), copper (Cu), silver (Ag), gold (Au), and tungsten (W) or an alloy containing one or more metals selected from the group.

### (Configuration 7)

The droplet sensor according to any one of the configurations 1 to 6, in which the platinum-containing material layer has a thickness of 5 nm or more and 150 nm or less.

### (Configuration 8)

The droplet sensor according to any one of configurations 1 to 7, in which the spacing between the first thin wire and the second thin wire is in a range of 100 nm or more and 100 µm or less.

### (Configuration 9)

The droplet sensor according to the configuration 8, in which the spacing between the first thin wire and the second thin wire is in a range of 100 nm or more and 10 µm or less.

### (Configuration 10]

A condensation detection device equipped with the droplet sensor according to any one of the configurations 1 to 9.

### (Configuration 11)

A method for manufacturing a droplet sensor or a condensation detection device, the method comprising:
producing an intermediate in which a pattern of a platinum-containing material layer composed of platinum or a platinum alloy is formed on an insulating substrate;
forming a first metal-containing material layer including a metal having a lower electrical resistivity than platinum on the intermediate; and
performing processes including single lithography to form a first electrode and a second electrode on the insulating substrate, the first electrode having a first thin wire formed of the first metal-containing material layer and a first current collector formed of the first metal-containing material layer, the second electrode having a second thin wire that is a composite film of the platinum-containing material layer and the first metal-containing material layer and a second current collector including the first metal-containing material layer, and the first thin wire and the second thin wire being alternately disposed in juxtaposition with each other on the insulating substrate.

### (Configuration 12)

A method for manufacturing a droplet sensor or a condensation detection device, the method comprising:
forming a first metal-containing material layer including a metal having a lower electrical resistivity than platinum on an insulating substrate;
producing an intermediate in which a pattern of a laminated body having a platinum-containing material layer composed of platinum or a platinum alloy is laminated on the first metal-containing material layer; and
performing processes including single lithography to form a first electrode and a second electrode on the insulating substrate, the first electrode having a first thin wire formed of the first metal-containing material layer and a first current collector formed of the first metal-containing material layer and a second electrode having a second thin wire that is a composite film of the platinum-containing material layer and the first metal-containing material layer, the second current collector including the first metal-containing material layer, and the first thin wire and the second thin wire being alternately disposed in juxtaposition with each other on the insulating substrate.

### (Configuration 13)

A method for manufacturing a droplet sensor or a condensation detection device in which a first electrode and a second electrode are formed on an insulating substrate, the first electrode having a first thin wire formed of a first metal-containing material layer including a metal having a lower electrical resistivity than platinum and a first current collector formed of the first metal-containing material layer, the second electrode having a second thin wire that is a composite film of the first metal-containing material layer and a platinum-containing material layer composed of platinum or a platinum alloy and a second current collector including the first metal-containing material layer, and the first thin wire and the second thin wire being alternately disposed in juxtaposition with each other on the insulating substrate,
the method comprising:
producing an intermediate on the insulating substrate by forming the first electrode and a temporary electrode that is formed of the first metal-containing material layer and has a pattern of the second electrode or a pattern obtained by lessening the pattern of the second electrode; and
forming the second electrode by forming the platinum-containing material layer on at least a surface of a thin wire of the temporary electrode of the intermediate by electroplating.

### (Configuration 14)

The method for manufacturing a droplet sensor or a condensation detection device according to the configuration 13, in which the first electrode and the temporary electrode are formed by single lift-off.

### (Configuration 15)

The method for manufacturing a droplet sensor or a condensation detection device according to the configuration 13, in which the first electrode and the temporary electrode are formed by single deposition, single lithography, and etching of the first metal-containing material on the insulating substrate.

### (Configuration 16)

A method for manufacturing a droplet sensor or a condensation detection device in which a first electrode and a second electrode are formed on an insulating substrate, the first electrode having a first thin wire formed of a first metal-containing material layer including a metal having a lower electrical resistivity than platinum and a first current collector formed of the first metal-containing material layer, the second electrode having a second thin wire that is a composite film of the first metal-containing material layer and a platinum-containing material layer composed of platinum or a platinum alloy and a second current collector including the first metal-containing material layer, and the first thin wire and the second thin wire being alternately disposed in juxtaposition with each other on the insulating substrate,
the method comprising:
forming the first metal-containing material layer and an oxide insulating film in sequence on the insulating substrate;
producing an intermediate on the insulating substrate by performing processes including single lithography to form the first electrode and a temporary electrode having a pattern of the second electrode or a pattern obtained by lessening the pattern of the second electrode;
allowing a platinum-containing material to adhere to the intermediate to form a platinum-containing material layer;
performing anisotropic etching to form the platinum-containing material layer only on a sidewall of the first thin wire of the first electrode and to form the second electrode having the platinum-containing material layer only on a sidewall of at least a thin wire of the temporary electrode;
forming a resist pattern obtained by broadening the pattern of the second electrode and performing etching to remove the platinum-containing material layer in a part not protected by the resist pattern; and
removing the resist pattern.

### (Configuration 17)

The method for manufacturing a droplet sensor or a condensation detection device according to the configuration 16, in which the oxide insulating film is composed of an oxide containing one or more substances selected from the group consisting of yttrium (Y), aluminum, silicon (Si), and cerium (Ce).

### (Configuration 18)

The method for manufacturing a droplet sensor or a condensation detection device according to any one of the configurations 11 to 17, in which the first metal-containing material layer is composed of one or more metals selected from the group consisting of aluminum, magnesium, zinc, iron, cobalt, nickel, molybdenum, copper, silver, gold, and tungsten or an alloy containing one or more metals selected from the group.

### (Configuration 19)

The method for manufacturing a droplet sensor or a condensation detection device according to any one of the configurations 11 to 18, in which the platinum-containing material layer has a thickness of 5 nm or more and 150 nm or less.

### (Configuration 20)

A method for manufacturing a droplet sensor or a condensation detection device according to any one of configurations 11 to 19, in which the spacing between the first thin wire and the second thin wire is in a range of 100 nm or more and 100 µm or less.

### Advantageous Effects of Invention

According to the present invention, there are provided a droplet sensor and a condensation detection device having stable detection properties and a method for manufacturing the same. Even when the droplet sensor and the condensation detection device are mass-produced, the present invention enables reduction of manufacturing variation between the elements and enables high detection accuracy and high electrical output of the elements.

### Brief Description of Drawings

Fig. 1 is a bird's-eye view for describing a configuration and operation of a galvanic-type droplet sensor 201.
Fig. 2(a) is a top view and Fig. 2(b) is a cross-sectional view showing configurations of main components in the galvanic-type droplet sensor 201.
Fig. 3 is a top view for describing one of the problems in a galvanic-type droplet sensor in the related art.
Fig. 4 is a cross-sectional view for describing configurations of main components in a galvanic-type droplet sensor according to the present invention.
Fig. 5 is a cross-sectional view showing a manufacturing process of a first galvanic-type droplet sensor 101 according to the present invention.
Fig. 6 is a plan view showing the manufacturing process of the first galvanic-type droplet sensor 101 according to the present invention.
Fig. 7 is a cross-sectional view showing a manufacturing process of a second galvanic-type droplet sensor 102 according to the present invention.
Fig. 8 is a plan view showing the manufacturing process of the second galvanic-type droplet sensor 102 according to the present invention.
Fig. 9 is a cross-sectional view showing a manufacturing process of a third galvanic-type droplet sensor 103 according to the present invention.
Fig. 10 is a plan view showing the manufacturing process of the third galvanic-type droplet sensor 103 according to the present invention.
Fig. 11 is a cross-sectional view showing a manufacturing process of a fourth galvanic-type droplet sensor 104 according to the present invention.
Fig. 12 is a plan view showing the manufacturing process of the fourth galvanic-type droplet sensor 104 according to the present invention.
Fig. 13 is a plan view for describing a configuration of a sample before Pt plating in Example 2.
Fig. 14 shows optical micrographs taken in Example 2. The left-side photograph shows an upper surface (a portion including a first thin wire and a first current collector) of the sample before Pt plating, and the right-side photograph shows the upper surface of the sample after performing Pt plating on an Al layer included in the first thin wire and the first current collector.
Fig. 15 shows optical micrographs taken in Example 2. The left-side photograph shows an upper surface (a portion including a second thin wire and a second current collector) of the sample before Pt plating, and the right-side photograph shows the upper surface of the sample after performing Pt plating on an Au layer included in the second thin wire and the second current collector.

### Description of Embodiments

### <Concept and Structure>

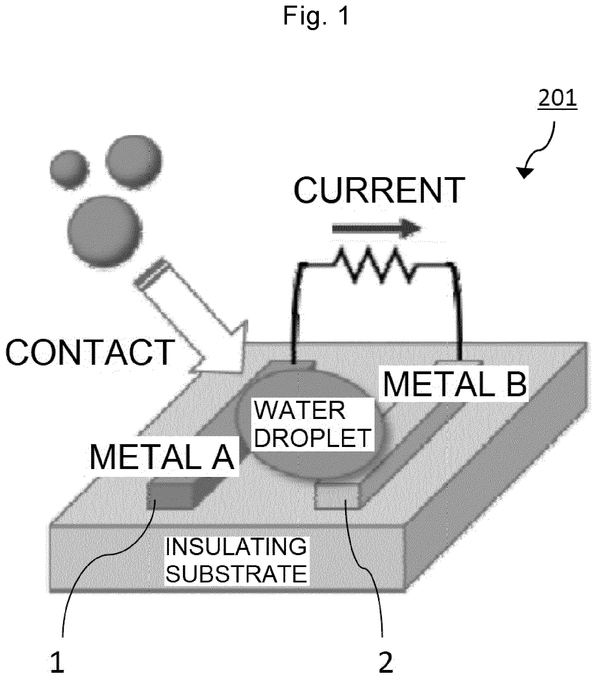

As shown in Fig. 1, a galvanic-type droplet sensor 201 is of a current sensing type in which thin wires composed of different metals (metal A and metal B) are disposed in juxtaposition with each other on an insulating substrate. When a conductive droplet such as a water drop spreads over and touches a gap between a first thin wire 1 and a second thin wire 2, a galvanic current flows between the thin wires. The galvanic-type droplet sensor 201 utilizes this phenomenon.

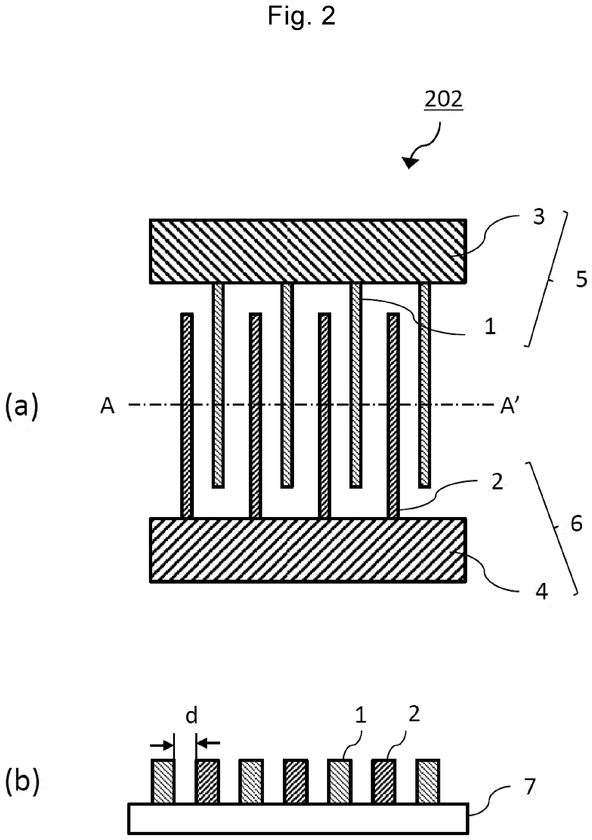

As shown in Fig. 2, an electrode 202 of the galvanic-type droplet sensor 201 is formed of the first thin wire 1, a first current collector 3 electrically connected to the first thin wire 1 (these members are collectively referred to as "first electrode 5"), the second thin wire 2, and a second current collector 4 electrically connected to the second thin wire 2 (these members are collectively referred to as "second electrode 6"). As described above, the metal included in the first thin wire 1 is different from one included in the second thin wire 2. From a wire-productivity point of view, it is preferable that the first thin wire 1 and the first current collector 3 include the same material and that the second thin wire 2 and the second current collector 4 include the same material. From an electrical resistance point of view, it is preferable that the first current collector 3 and the second current collector 4 include the same material and that wires drawn out of the galvanic-type droplet sensor 201 include the same material. Fig. 2(a) is a top view and Fig. 2(b) is a cross-sectional view taken along line A-A' in Fig. 2(a) in which the reference numeral 7 indicates an insulating substrate and the symbol d indicates a spacing between the first thin wire 1 and the second thin wire 2.

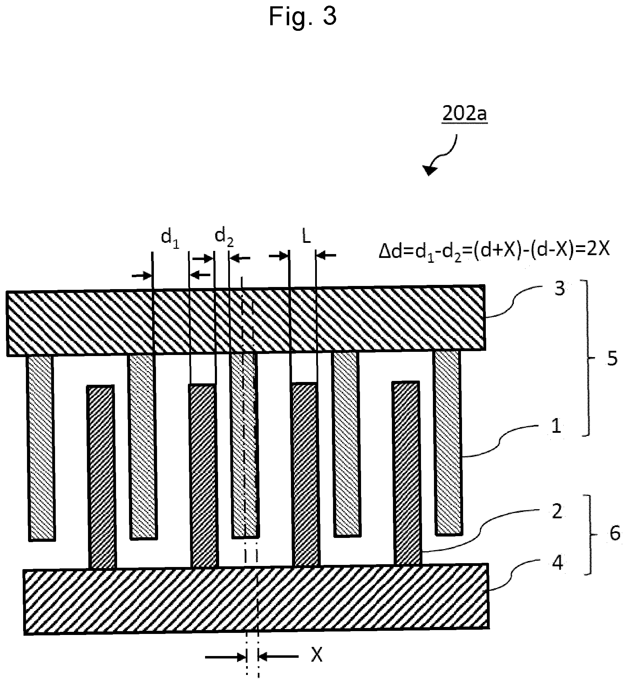

The galvanic-type droplet sensor 201 in the related art uses different materials (metals) for the first thin wire 1 and the second thin wire 2, which requires separate lithographic processes in manufacturing, that is, first lithography for forming the first thin wire 1 and second lithography for forming the second thin wire 2. Such separate processes inevitably cause misalignment between the first and second lithography. This misalignment is shown in Fig. 3 in which a pattern 202a of the electrodes (thin wires and current collectors) of the galvanic-type droplet sensor 201 is viewed from above.

In the galvanic-type droplet sensor 201, not only widths L of the first thin wire 1 and the second thin wire 2 are minute but also a spacing d between the first thin wire 1 and the second thin wire 2 is narrow. Considering the misalignment X during manufacturing, a wide spacing d₁ becomes (d + X), and a narrow spacing d₂ becomes (d - X), and a difference Δd = d₁ - d₂ between the wide spacing d₁ and the narrow spacing d₂ becomes (d + X) - (d - X) = 2X.

Typically, the alignment accuracy in lithography is 1/5 to 1/4 of a width of a formed pattern. Therefore, for example, in a case where a design spacing d is 1 µm, a misalignment allowance is in the range of from 0.2 to 0.25 µm. In this case, the spacing d between formed patterns varies from 0.75 µm to 1.25 µm. Relative to the design value, 1 µm, the spacing d deviates up to 0.5 µm (Δd = 2 × 0.25).

Since the galvanic-type droplet sensor 201 detects contact of a droplet with the first thin wire 1 and the second thin wire 2, the spacing d between the first thin wire 1 and the second thin wire 2 directly affects the size of a droplet to be detected. For this reason, the accuracy of the spacing d is highly important for the galvanic-type droplet sensor 201. Large misalignment as described above is unacceptable, and it is necessary to sift out products that have the spacing d falling within the allowance, which leads to a low yield rate.

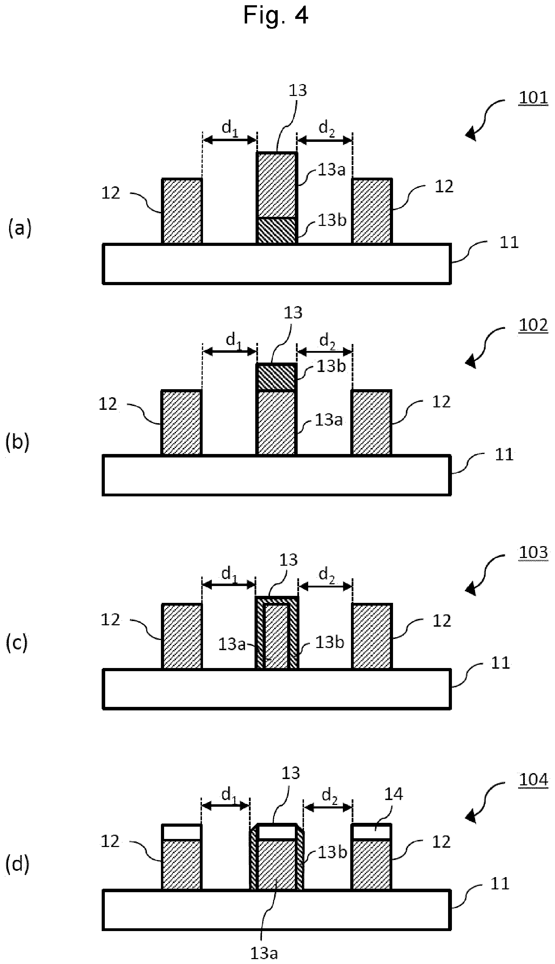

Fig. 4 shows structures of thin wires included in droplet detectors which are main components of galvanic-type droplet sensors according to an embodiment of the present invention. The structures are roughly classified into four kinds as shown in Figs. 4(a) to 4(d). First to fourth galvanic-type droplet sensors 101 to 104 each have a first thin wire formed of a first metal-containing material layer having a lower electrical resistivity than platinum and a second thin wire that is a composite film of the first metal-containing material layer and a platinum-containing material layer such as platinum or a platinum alloy. Although not shown in Fig. 4, the first to fourth galvanic-type droplet sensors 101 to 104 each have a first current collector formed of the first metal-containing material layer and a second current collector including the first metal-containing material layer.

In each second thin wire, at least a part of a surface of the platinum-containing material layer is exposed to the outside. In other words, each second thin wire is formed in such a manner that at least a part of the surface of the platinum-containing material layer included in the composite film is exposed to the outside, and a conductive droplet is brought into contact with the exposed part. It should be noted that the expression "exposed to the outside" in this context signifies that a droplet sensor is in an environment where it can be touched by a droplet to be detected, and the expression does not signify whether the droplet sensor itself is placed in an open or closed space.

In each of the first to fourth galvanic-type droplet sensors 101 to 104, the arrangement of a first thin wire 12 and a second thin wire 13 is determined by single lithography as will be described later in the section of a manufacturing method, whereby the spacings d₁ and d₂ between the first thin wire 12 and the second thin wire 13 can be the same value. Accordingly, it is possible to prevent degradation of accuracy in droplet detection which is attributed to variation in spacing between the thin wires.

In addition, since each second thin wire 13 is a composite film of a layer composed of a platinum-containing material such as platinum or a platinum alloy which produces a high galvanic effect (high current by electromotive force) and a layer composed of a first metal-containing material which is an electrical conductor having a lower resistivity than platinum, it is possible to increase a galvanic current when a conductive droplet spreads over a gap between the first thin wire 12 and the second thin wire 13. Accordingly, it is possible to enhance droplet detection sensitivity of the droplet sensors.

Furthermore, first and second current collectors corresponding to the first current collector 3 and the second current collector 4 of electrodes of a galvanic-type droplet sensor in the related art can also be made of the first metal-containing material without a special process, and output terminals of each droplet sensor can be made with one material. Such a configuration also makes it possible to avoid a problem of a contact potential when the droplet sensors are connected to another device such as an amplifier, analyzer, and alarm system.

Examples of the first metal-containing material include one or more metals selected from the group consisting of aluminum (Al), magnesium (Mg), zinc (Zn), iron (Fe), cobalt (Co), nickel (Ni), molybdenum (Mo), copper (Cu), silver (Ag), gold (Au), and tungsten (W) or an alloy containing one or more metals selected from the group.

Among these examples, Al is particularly preferable from viewpoints of low electrical resistance, tractability, versatile application, low material cost, and low process cost. Examples of an Al alloy include Al-Cu, Al-Si, Al-Cu-Si, Al-Mn, Al-Mg, Al-Mg-Si, Al-Mg-Zn, and Al-Mg-Zn-Cu. Using an alloy enhances various properties such as electromigration, electrical resistivity, tractability, bending resistance, hardness, flexibility, reflectance control contributing to halation suppression in photolithography, corrosion resistance, abrasion resistance, adhesion to dissimilar materials, hydrophilicity, and hydrophobicity.

Examples of a platinum alloy include Pt-Au, Pt-Pd, Pt-Ir, Pt-Rh, Pt-Co, Pt-Fe, and Pt-Cr. Using a platinum alloy brings about effects such as enhancement in conductivity, catalytic activity, temperature coefficient, and toxicity and reduction in amount of platinum used.

As shown in Fig. 4(a), in the structure of the first galvanic-type droplet sensor 101, the first thin wire 12 and the second thin wire 13 are formed on an insulating substrate 11. The first thin wire 12 is formed of a first metal-containing material layer having a lower electrical resistivity than platinum. The second thin wire 13 is a two-layered film having 13a composed of the same material as the first thin wire 12 as an upper layer and 13b composed of a platinum-containing material as a lower layer.

This structure has the following characteristics. Since the lower layer of the second thin wire includes the platinum-containing material, even when the quantity of droplet is so small as to accumulate at the bottom of a space between the thin wires (that is, the droplet is on the insulating substrate and spreads over the space between the thin wires), it is possible to detect the droplet.

The first thin wire 12 is electrically connected to a first current collector, the second thin wire 13 is electrically connected to a second current collector, and the first and second current collectors are connected to signal output terminals via electrical wires (not shown) connected thereto. An amplifier may be connected to the first current collector and the second current collector to amplify a galvanic current that flows due to the presence of a droplet.

A galvanic current flows when a first metal is connected by a conductive droplet such as a water drop to a second metal that is different in electrochemical potential from the first metal. Ultrapure water has insulating properties due to its low conductivity. However, in a case where a droplet contains a small quantity of electrolytic components due to hydrogen ions and hydroxide ions that exist at least in an amount of 10⁻⁷ mol/L or due to contamination, a measurable (sensible) galvanic current flows.

In this structure, by using two kinds of thin wires obtained by thinning wires, it is possible to increase a length of the portions of both the thin wires facing each other with approaching each other with respect to the area of the droplet detector on the substrate (an area of a region where the first electrode and the second electrode are arranged). Thus, it is possible to increase a galvanic current to be taken out.

As a configuration for increasing a length (hereinafter, referred to as an approaching distance) of approached portions between thin wires by arranging such thin wires in parallel with and approached each other, for example, a comb structure or a double spirally-wound structure may be employed. In addition, a structure itself for increasing an approaching distance between two thin wires inside a predetermined plane area as possibly as can be is well known in the field of a semiconductor device and the like, and thus, such a structure may be employed as is necessary. In the present invention, "juxtaposing thin wires on a substrate" is not for specifying mutual directions of a plurality of thin wires placed on the substrate but represents that the thin wires are arranged on a same plane of the substrate with being separate from each other.

As shown in Fig. 4(b), the structure of the second galvanic-type droplet sensor 102 is obtained by reversing the lamination sequence of a laminated film in the second thin wire 13 of the first galvanic-type droplet sensor 101. In the structure of the second galvanic-type droplet sensor 102, the first thin wire 12 formed of the first metal-containing material layer having a lower electrical resistivity than platinum and the second thin wire 13 which is a two-layered film having 13b composed of the platinum-containing material as an upper layer and 13a composed of the same material as the first thin wire 12 as a lower layer are formed on the insulating substrate 11.

This structure has the following characteristics. Since the upper layer of the second thin wire includes the platinum-containing material, when a relatively large droplet spreading over upper portions of the first thin wire and the second thin wire are detected by a galvanic effect, it is possible to enhance the galvanic effect by the platinum-containing material in the upper layer of the second thin wire, and simultaneously, it is possible to increase a current due to the low electrical resistance of the first metal-containing material in the lower layer (that is, it is possible to supply a sufficient current to the platinum-containing material included in the upper layer from the first metal-containing material included in the lower layer).

As shown in Fig. 4(c), in the structure of the third galvanic-type droplet sensor 103, the first thin wire 12 formed of the first metal-containing material layer having a lower electrical resistivity than platinum and the second thin wire 13 which is a composite film having 13a composed of the same material as the first thin wire 12 as a core (base layer) and 13b formed of the platinum-containing material layer as a layer for covering the core are formed on the insulating substrate 11.

This structure has the following characteristics. Since a part of the second thin wire 13 exposed to the outside is entirely composed of the platinum-containing material and the first metal-containing material in the core significantly reduces the electrical resistance, it is possible to stably obtain high droplet detection sensitivity.

As shown in Fig. 4(d), in the structure of the fourth galvanic-type droplet sensor 104, the first thin wire 12 formed of the first metal-containing material layer having a lower electrical resistivity than platinum and having an upper surface capped with an oxide insulating film 14 and the second thin wire 13 which is a composite film having 13a composed of the same material as the first thin wire 12 as a core (base layer), 13b formed of the platinum-containing material layer and formed on a sidewall of the core, and the oxide insulating film 14 formed on an upper surface of the second thin wire 13 as a cap are formed on the insulating substrate 11.

In manufacturing of a sensor, the oxide insulating film 14 functions as an etching mask when the first metal-containing material layer is etched and functions as a protective cap for protecting the first and second thin wires. The oxide insulating film 14 also has a function which enables rapid detection and response according to a droplet size by making the upper surfaces of the first and second thin wires insulative and limiting a path of a galvanic current to the sidewalls of the first and second thin wires. Furthermore, making the oxide insulating film 14 with a hydrophobic or hydrophilic material to control the droplet wettability provides the oxide insulating film 14 with a function of controlling detection properties for enhancing the detection and response according to a droplet size.

The oxide insulating film 14 is not particularly limited in material as long as it serves the above functions, but particularly preferable examples of the material include oxides containing one or more substances selected from the group consisting of yttrium (Y), aluminum, silicon (Si), and cerium (Ce), specifically, Y₂O₃, Al₂O₃, SiO₂, and CeO₂.

This structure has the following characteristics. Since parts that sense contact of a droplet are only the sidewalls of the first thin wire 12 and the second thin wire formed of the platinum-containing material layer 13b having constant spacings d₁ and d₂ therebetween, the detection and response according to a droplet size becomes rapid (a current-time curve becomes steep). Such a configuration makes it easier to specify the size of a droplet to be detected.

In the first to fourth galvanic-type droplet sensors 101 to 104, the expression "constant spacings d₁ and d₂" does not limit the spacings d₁ and d₂ to exactly the same measured value. In other words, the expression "constant spacings" between the first thin wire 12 and the second thin wire 13 not only indicates that spacings between the first thin wire 12 and the second thin wire 13 are exactly the same but also indicates that there is an allowable error caused by measurement accuracy (reproducibility) of a device such as CD-SEM (CD-SEM) used for the measurement.

In each of the first to fourth galvanic-type droplet sensors 101 to 104, a spacing between the first thin wire 12 and the second thin wire 13 in the droplet detector (a region with the first electrode that has the first thin wire 12 and the first current collector and the second electrode that has the second thin wire 13 and the second current collector) on the insulating substrate 11 is preferably 100 nm or more and 100 µm or less, and more preferably, 100 nm or more and 10 µm or less. These ranges enable droplet detection with high sensitivity.

The platinum-containing material layer 13b preferably has a thickness of 5 nm or more and 150 nm or less. Designing the thickness of the platinum-containing material layer 13b to 5 nm or more makes it easier to ensure the uniformity of thickness of the platinum-containing material layer when manufacturing a sensor, which reduces a place where the platinum-containing material layer is not formed, that is, what is called a defective portion. Accordingly, it is possible to obtain high accuracy in droplet detection. In addition, designing the thickness of the platinum-containing material layer 13b to 150 nm or less increases a ratio of the first metal-containing material, within the second thin wire, which is relatively lower in electrical resistivity than the platinum-containing material and easily reduces the electrical resistance of the second thin wire. It is also possible to reduce an amount of costly platinum. Since a galvanic-type droplet sensor is of a current sensing type, it is highly important to reduce the electrical resistance of a part that senses contact of a droplet in order to obtain high droplet detection sensitivity.

### <Method for Manufacturing First Structure>

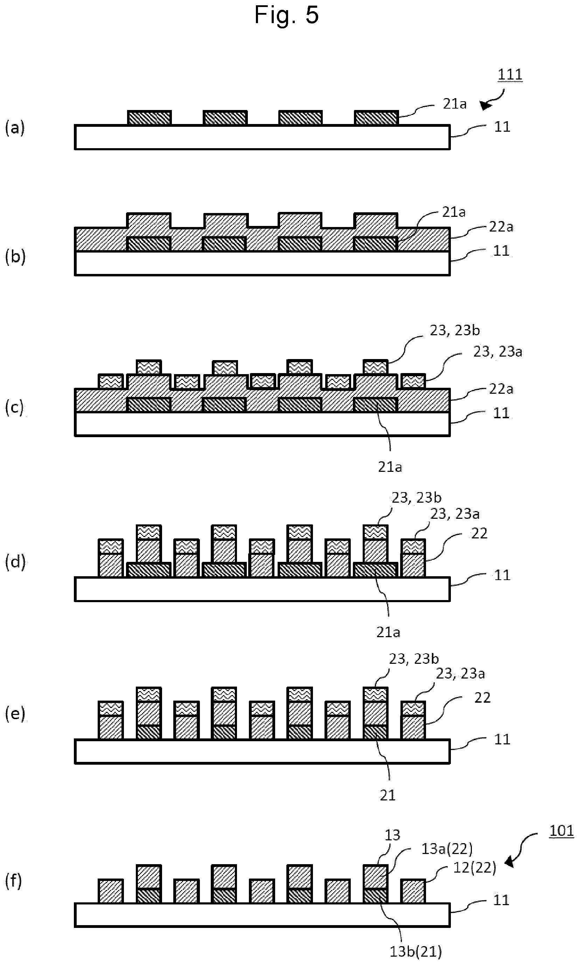

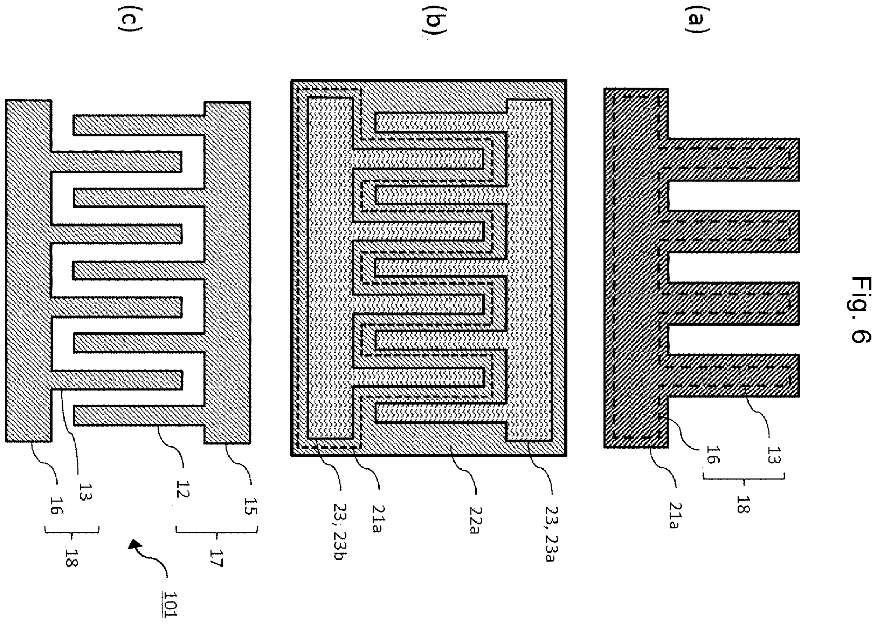

A method for manufacturing the first galvanic-type droplet sensor 101 will be described with reference to a cross-sectional view of Fig. 5 and a plan view of Fig. 6.

First, the insulating substrate 11 is prepared, and a platinum-containing material layer pattern 21a composed of a platinum-containing material is formed on the insulating substrate 11 to produce an intermediate 111 (see Fig. 5(a)).

Examples of the insulating substrate 11 include substrates having a SiO₂ oxide film on a Si wafer, substrates made of glass such as synthetic quartz glass and soda-lime glass, substrates made of plastic such as acrylic, polystyrene (PS), polypropylene (PP), polyethylene terephthalate (PET), and polycarbonate (PC), and substrates obtained by forming a layer made of resin such as acrylic resin, methacrylate resin, novolak resin, polyester resin, polyamide resin, polyimide resin, polyamideimide resin, and silicone resin on the above substrates.

The platinum-containing material layer pattern 21a is obtained by broadening a pattern of the second electrode 18 to be eventually formed in which the second thin wire 13 and the second current collector 16 are integrated (see Fig. 6(a)). The degree of broadening is determined in consideration of the degree of misalignment between lithographic processes.

Examples of a method for forming the platinum-containing material layer pattern 21a include a method consisting of processes including depositing a thin film of a platinum-containing material such as Pt, lithography, and etching, and also include lift-off. Examples of a method for depositing the thin film of the platinum-containing material include sputtering, vapor deposition, chemical vapor deposition (CVD), and coating.

Next, a first metal-containing material to be included in the first electrode in which the first thin wire and the first current collector are integrated is deposited on the intermediate 111 to form a first metal-containing material layer 22a (see Fig. 5(b)). An example of the first metal-containing material includes Al. Examples of a method for depositing the first metal-containing material (method for forming the first metal-containing material layer 22a) include sputtering, vapor deposition, and CVD.

The next step is to form, by single exposure, a resist pattern 23 including a resist pattern 23a of the first electrode 17 having the first thin wire 12 and the first current collector 15 which are to be eventually formed and a resist pattern 23b of the second electrode 18 having the second thin wire 13 and the second current collector 16 which are to be eventually formed (see Figs. 5(c) and 6(b)).

Then, the first metal-containing material layer 22a is etched using the resist pattern 23 as an etching mask, thereby forming a first metal-containing material layer pattern 22 (see Fig. 5(d)). Continuously, the platinum-containing material layer pattern 21a is also etched using the resist pattern 23 as an etching mask, thereby forming a platinum-containing material layer pattern 21 (see Fig. 5(e)). In a case where Al is used as the first metal-containing material, a chlorine-based gas, bromine-based gas, iodine-based gas, and other gases are applicable as an etching gas.

Next, the resist pattern 23 is removed by ashing or with a stripping liquid to produce the first galvanic-type droplet sensor 101 provided with the first electrode 17 that has the first thin wire 12 and the first current collector 15 and the second electrode 18 that has the second thin wire 13 and the second current collector 16 (see Figs. 5(f) and 6(c)). The first thin wire 12 is a part of the first metal-containing material layer pattern 22, and the second thin wire 13 includes a part of the first metal-containing material layer pattern 22 (13a) and a part of the platinum-containing material layer pattern 21 formed of a platinum-containing material layer (13b). In this method, the first current collector 15 having the same configuration as the first thin wire 12 can be formed simultaneously with the first thin wire 12 and the second current collector 16 having the same configuration as the second thin wire 13 can be formed simultaneously with the second thin wire 13. That is to say, in this method, the first electrode 17 having the integrated first thin wire 12 and first current collector 15 and the second electrode 18 having the integrated second thin wire 13 and second current collector 16 are formed, and a region provided with the first electrode 17 and the second electrode 18 is included in the droplet detector of the first galvanic-type droplet sensor 101.

In the first galvanic-type droplet sensor 101 manufactured in this way, the arrangement of the first thin wire 12 and the second thin wire 13 (that is, the arrangement of the first electrode 17 and the second electrode 18) is determined by the resist pattern 23 formed by single exposure, whereby the difference Δd of the spacings d₁ and d₂ between the first thin wire 12 and the second thin wire 13 is reduced to 0. Accordingly, it is possible to prevent degradation of accuracy in droplet detection which is attributed to variation in spacing between the thin wires.

In addition, the second current collector 16 has the same configuration as the second thin wire 13, having an upper layer formed of the first metal-containing material layer and including the same material as the first current collector 15. Accordingly, wires drawn out of the first galvanic-type droplet sensor 101 include the same material. For this reason, the first galvanic-type droplet sensor 101 manufactured by this method has a preferable structure even from the electrical resistance point of view.

### <Method for Manufacturing Second Structure>

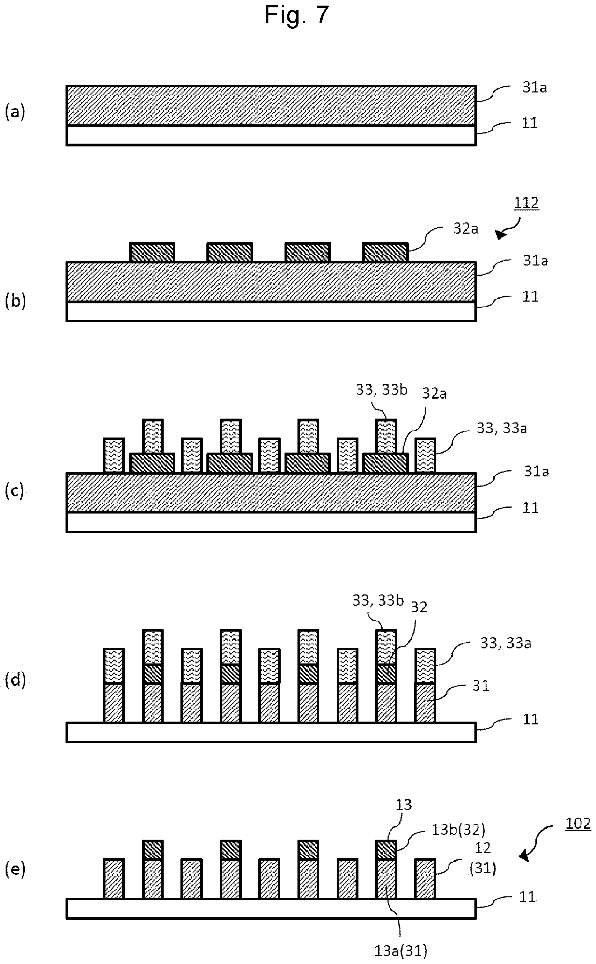

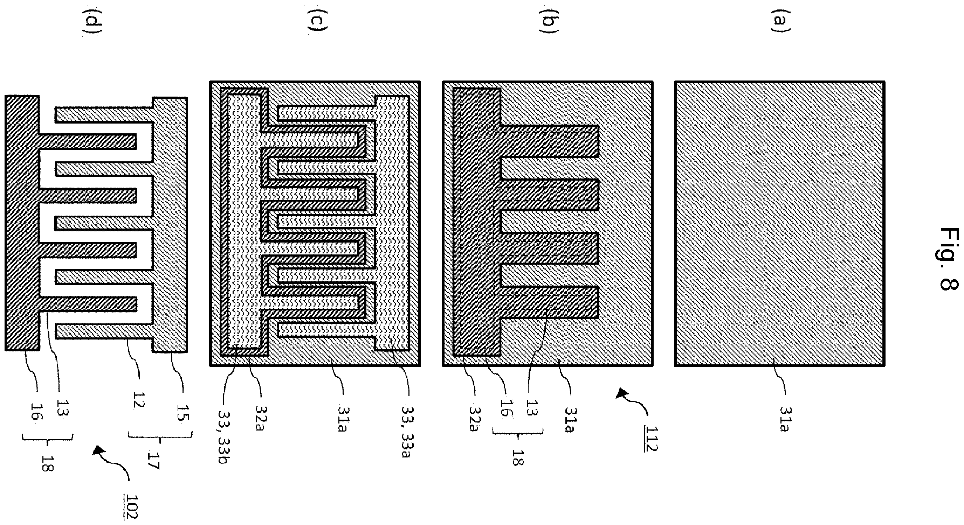

A method for manufacturing the second galvanic-type droplet sensor 102 will be described with reference to a cross-sectional view of Fig. 7 and a plan view of Fig. 8.

First, the insulating substrate 11 is prepared, and a first metal-containing material such as Al having a lower electrical resistivity than platinum is deposited on the insulating substrate 11, thereby forming a first metal-containing material layer 31a (see Figs. 7(a) and 8(a)). As the insulating substrate 11, a substrate similar to one described in the method for manufacturing the first structure is used. Examples of a method for depositing the first metal-containing material (method for forming the first metal-containing material layer 31a) include sputtering, vapor deposition, and CVD.

Next, a platinum-containing material layer pattern 32a composed of a platinum-containing material is formed (laminated) on the first metal-containing material layer 31a to produce an intermediate 112 (see Figs. 7(b) and 8(b)).

The platinum-containing material layer pattern 32a is obtained by broadening a pattern of the second electrode 18 to be eventually formed in which the second thin wire 13 and the second current collector 16 are integrated (see Fig. 8(b)). The degree of broadening is determined in consideration of the degree of misalignment between lithographic processes.

Examples of a method for forming the platinum-containing material layer pattern 32a include a method consisting of processes including depositing a thin film of a platinum-containing material such as Pt, lithography, and etching and also include lift-off. Examples of a method for depositing the thin film of the platinum-containing material include sputtering, vapor deposition, CVD, coating, and plating.

The next step is to form, by single exposure, a resist pattern 33 including a resist pattern 33a of the first electrode 17 having the first thin wire 12 and the first current collector 15 which are to be eventually formed and a resist pattern 33b of the second electrode 18 having the second thin wire 13 and the second current collector 16 which are to be eventually formed (see Figs. 7(c) and 8(c)).

Then, the platinum-containing material layer pattern 32a and the first metal-containing material layer 31a are etched using the resist pattern 33 as an etching mask, thereby forming a platinum-containing material layer pattern 32 and a first metal-containing material layer pattern 31 (see Fig. 7(d)). In a case where Al is used as the first metal-containing material, a chlorine-based gas, bromine-based gas, iodine-based gas, and other gases are applicable as an etching gas.

Next, the resist pattern 33 is removed by ashing or with a stripping liquid to produce the second galvanic-type droplet sensor 102 provided with the first electrode 17 that has the first thin wire 12 and the first current collector 15 and the second electrode 18 that has the second thin wire 13 and the second current collector 16 (see Figs. 7(e) and 8(d)). The first thin wire 12 is a part of the first metal-containing material layer pattern 31, and the second thin wire 13 includes a part of the first metal-containing material layer pattern 31 (13a) and a part of the platinum-containing material layer pattern 32 formed of a platinum-containing material layer (13b). In this method, the first current collector 15 having the same configuration as the first thin wire 12 can be formed simultaneously with the first thin wire 12 and the second current collector 16 having the same configuration as the second thin wire 13 can be formed simultaneously with the second thin wire 13. That is to say, in this method, the first electrode 17 having the integrated first thin wire 12 and first current collector 15 and the second electrode 18 having the integrated second thin wire 13 and second current collector 16 are formed, and a region provided with the first electrode 17 and the second electrode 18 is included in the droplet detector of the second galvanic-type droplet sensor 102.

In the second galvanic-type droplet sensor 102 manufactured in this way, the arrangement of the first thin wire 12 and the second thin wire 13 (that is, the arrangement of the first electrode 17 and the second electrode 18) is determined by the resist pattern 33 formed by single exposure, whereby the difference Δd of the spacings d₁ and d₂ between the first thin wire 12 and the second thin wire 13 is reduced to 0. Accordingly, it is possible to prevent degradation of accuracy in droplet detection which is attributed to variation in spacing between the thin wires.

In addition, the second current collector 16 has the same configuration as the second thin wire 13, having a lower layer formed of the first metal-containing material layer and including the same material as the first current collector 15. Accordingly, wires drawn out of the second galvanic-type droplet sensor 102 include the same material. For this reason, the second galvanic-type droplet sensor 102 manufactured by this method has a preferable structure even from the electrical resistance point of view.

### <Method for Manufacturing Third Structure>

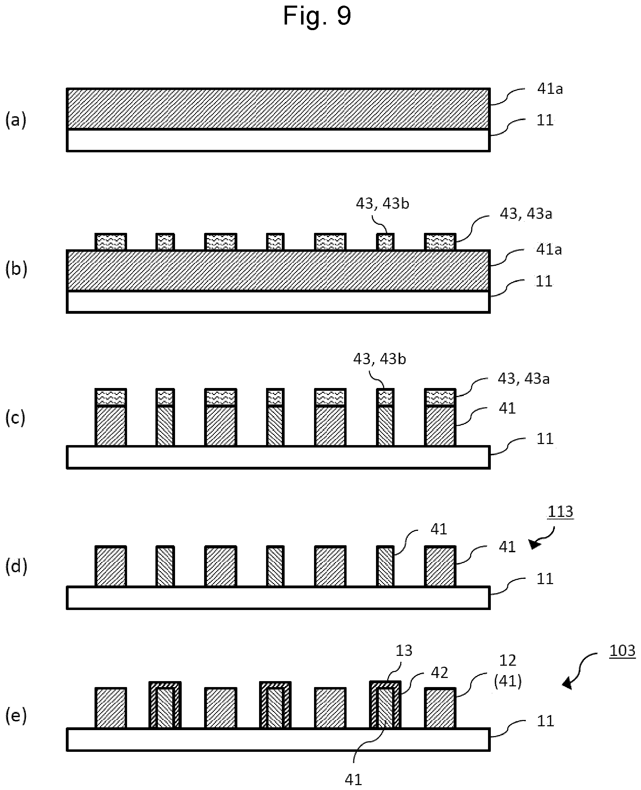

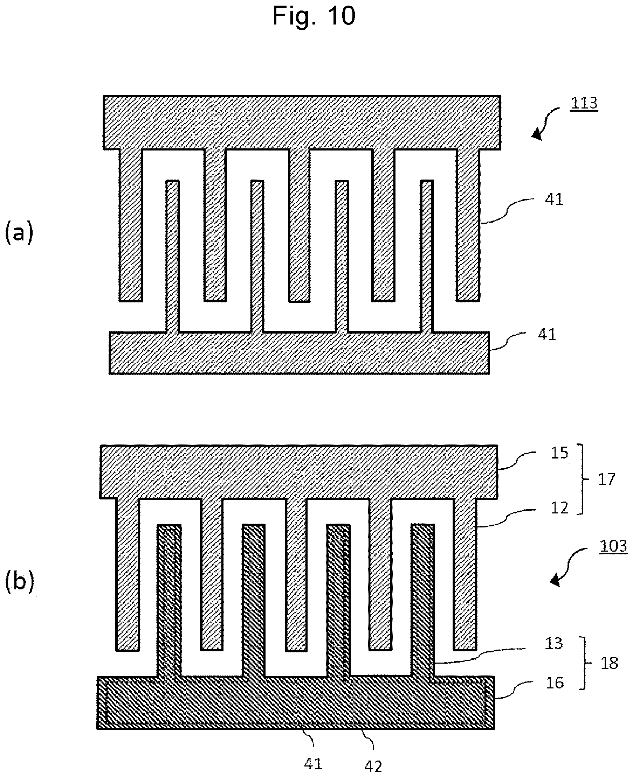

A method for manufacturing the third galvanic-type droplet sensor 103 will be described with reference to a cross-sectional view of Fig. 9 and a plan view of Fig. 10.

First, the insulating substrate 11 is prepared, and a first metal-containing material such as Al having a lower electrical resistivity than platinum is deposited on the insulating substrate 11, thereby forming a first metal-containing material layer 41a (see Fig. 9(a)). As the insulating substrate 11, a substrate similar to one described in the method for manufacturing the first structure is used. Examples of a method for depositing the first metal-containing material (method for forming the first metal-containing material layer 41a) include sputtering, vapor deposition, and CVD.

Next, a resist pattern 43 is formed (see Fig. 9(b)).

The resist pattern 43 includes a resist pattern 43b obtained by lessening a pattern of the second electrode 18 to be eventually formed in which the second thin wire 13 and the second current collector 16 are integrated and a resist pattern 43a obtained by merging a pattern of the first electrode 17 in which the first thin wire 12 and the first current collector 15 are integrated. The degree of lessening is determined by reference to the thickness of a platinum-containing material layer formed on a sidewall of the second thin wire.

Next, the first metal-containing material layer 41a is etched using the resist pattern 43 as an etching mask. In a case where Al is used as the first metal-containing material, a chlorine-based gas, bromine-based gas, iodine-based gas, and other gases are applicable as an etching gas.

Then, the resist pattern 43 is removed by ashing or with a stripping liquid to form a first metal-containing material layer pattern 41, thereby producing an intermediate 113 (see Figs. 9(d) and 10(a)). At this time, in the first metal-containing material layer pattern 41 formed with the resist pattern 43b, a part corresponding to the second electrode to be eventually formed serves as a temporary electrode (that is, a part including a temporary thin wire corresponding to the second thin wire and a temporary current collector corresponding to the second current collector).

Next, the intermediate 113 (the insulating substrate 11 with the first metal-containing material layer pattern 41) is immersed in an electroplating electrolyte solution, and a voltage is applied to the temporary electrode (that is, a pattern which is to be the second thin wire and the second current collector) of the first metal-containing material layer pattern 41 so as to coat a surface of the temporary electrode (the pattern to be the second thin wire and the second current collector) with a platinum-containing material, thereby forming the second electrode 18 having the second thin wire 13 and the second current collector 16 in which the first metal-containing material layer pattern 41 serving as a core (base layer) is covered with a platinum-containing material layer 42 (see Figs. 9(e) and 10(b)).

In the first metal-containing material layer pattern 41, a part to which no voltage is applied becomes the first electrode 17 having the first thin wire 12 and the first current collector 15 formed of the first metal-containing material layer. In this manner, the third galvanic-type droplet sensor 103 is produced.

During electroplating, it is preferable that a resist pattern is formed to cover a part to which no voltage is applied (a part of a pattern to be the first thin wire and the first current collector) so as to prevent defects due to the plating.

In the third galvanic-type droplet sensor 103 manufactured in this way, the arrangement of the first thin wire 12 and the second thin wire 13 (that is, the arrangement of the first electrode 17 and the second electrode 18) is determined by the resist pattern 43 formed by single exposure, which prevents variation in spacing between the first thin wire 12 and the second thin wire 13 and prevents degradation of accuracy in droplet detection which is attributed to variation in spacing between the thin wires.

In addition, the second current collector 16 has the same configuration as the second thin wire 13, having the core (base layer) formed of the first metal-containing material layer and including the same material as the first current collector 15. Accordingly, wires drawn out of the third galvanic-type droplet sensor 103 include the same material. For this reason, the third galvanic-type droplet sensor 103 manufactured by this method has a preferable structure even from the electrical resistance point of view.

### <Method for Manufacturing Fourth Structure>

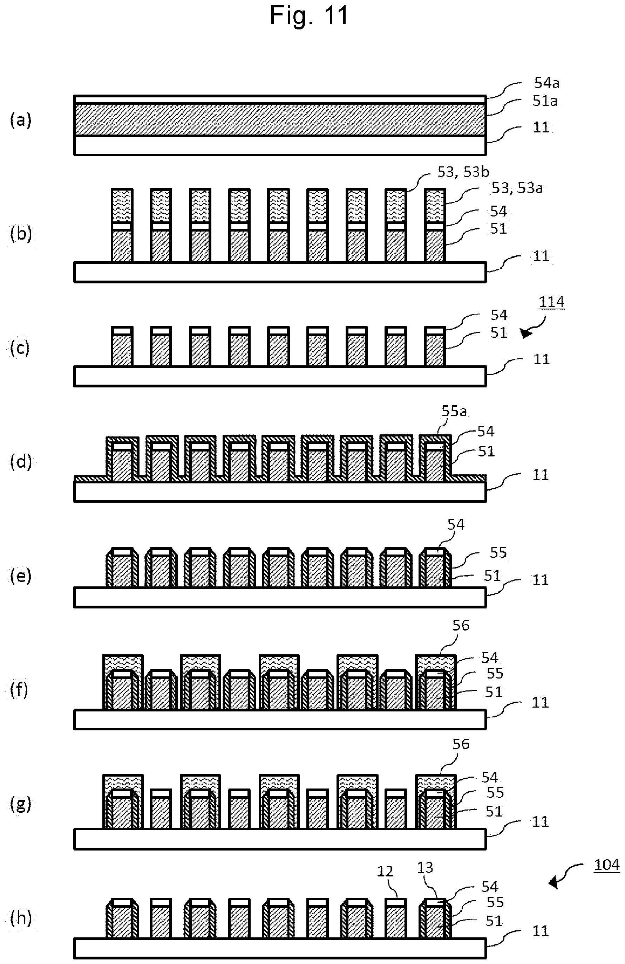

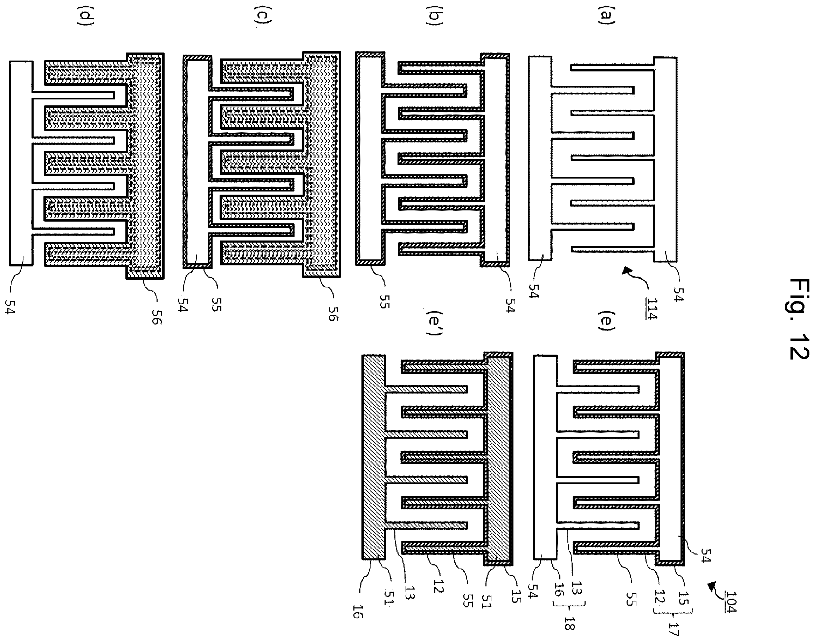

A method for manufacturing the fourth galvanic-type droplet sensor 104 will be described with reference to a cross-sectional view of Fig. 11 and a plan view of Fig. 12.

First, the insulating substrate 11 is prepared, and a first metal-containing material such as Al having a lower electrical resistivity than platinum is deposited on the insulating substrate 11 to form a first metal-containing material layer 51a, followed by forming an oxide insulating film 54a (see Fig. 11 (a)).

As the insulating substrate 11, a substrate similar to one described in the method for manufacturing the first structure is used.

Examples of a method for depositing the first metal-containing material (method for forming the first metal-containing material layer 51a) include sputtering, vapor deposition, and CVD.

Particularly preferable examples of a material of the oxide insulating film 54a include oxides containing one or more substances selected from the group consisting of yttrium (Y), aluminum, silicon (Si), and cerium (Ce), specifically, Y₂O₃, Al₂O₃, SiO₂, and CeO₂, and these films are formed by sputtering, CVD, spin coating, or the like. The oxide insulating film 54a preferably has a thickness equivalent to or more than a thickness of the first metal-containing material layer 51a after etching.

Next, a resist pattern 53 is formed.

The resist pattern 53 includes a resist pattern 53b obtained by lessening a pattern of the second electrode 18 to be eventually formed in which the second thin wire 13 and the second current collector 16 are integrated and a resist pattern 53a obtained by merging a pattern of the first electrode 17 in which the first thin wire 12 and the first current collector 15 are integrated. The degree of lessening is determined by reference to the thickness of a platinum-containing material layer formed on a sidewall of the second thin wire, but the lessening can be omitted. This is because it is a spacing between first and second thin wires that is important for a galvanic-type droplet sensor to detect a droplet, and widths of the first and second thin wires have an insignificant effect. In particular, in the fourth galvanic-type droplet sensor 104, since places where two kinds of metals are formed (places where a droplet spreads between the two kinds of metals) are only sidewalls of the thin wires, widths of the first and second thin wires make little impact on droplet detection properties.

Next, the oxide insulating film 54a is etched using the resist pattern 53 as an etching mask, followed by etching the first metal-containing material layer 51a (Fig. 11(b)).

When etching the first metal-containing material layer 51a, the resist pattern 53 may be allowed to stand, and both the resist pattern 53 and an oxide insulating film pattern 54 may be used as etching masks. Alternatively, the resist pattern 53 may be removed and the oxide insulating film pattern 54 may be used as an etching mask (Fig. 11(b) shows the former case where the resist pattern 53 is allowed to stand).

A fluorine-based gas is preferable as an etching gas for the oxide insulating film 54a, and a chlorine-based gas, bromine-based gas, or iodine-based gas to which oxygen is added is preferable as an etching gas for the first metal-containing material layer 51a.

Then, the resist pattern 53 is removed by ashing or with a stripping liquid to form a pattern formed of the oxide insulating film pattern 54 and a first metal-containing material layer pattern 51, thereby producing an intermediate 114 (see Figs. 11(c) and 12(a)).

Next, a platinum-containing material is made to adhere to the intermediate 114 (the insulating substrate 11 with the aforementioned pattern) to form a platinum-containing material layer 55a (Fig. 11(d)). The adhesion of the platinum-containing material is preferably conformal adhesion.

Examples of the adhesion include sputtering, vapor deposition, and CVD and also include electroplating. In a case where electroplating is employed, the intermediate 114 (the insulating substrate 11 with the aforementioned pattern) is immersed in a plating solution, and a voltage is applied to the first metal-containing material layer pattern 51.

Then, the platinum-containing material layer formed on a flat surface (a surface parallel to a surface of the insulating substrate 11) is removed by anisotropic etching, whereby a platinum-containing material layer 55 is left on a sidewall of the first metal-containing material layer pattern 51 (a surface substantially perpendicular to the surface of the insulating substrate 11) (see Figs. 11(e) and 12(b)).

In a case where a platinum-containing material adheres by electroplating, the platinum-containing material is not plated on an insulating material, and a structure as shown in Fig. 11(e) is obtained without going through full-coverage adhesion as shown in Fig. 11(d) (a state where the platinum-containing material layer is formed on both the surface of the insulating substrate 11 and on the pattern formed on the surface) and adheres only to the sidewall of the first metal-containing material layer pattern 51 where the conductive material is exposed. Accordingly, the electroplating has a benefit of reducing the number of steps. On the other hand, a combination of adhesion and anisotropic etching for forming the platinum-containing material layer on the sidewall of the first metal-containing material layer pattern 51 brings excellent shape controllability.

The next step is to form a resist pattern 56 to cover parts which are to be the first thin wire 12 and the first current collector 15 (a part to be the first electrode 17) (see Figs. 11(f) and 12(c)), and a part of the platinum-containing material layer not covered with the resist is removed by a wet etching solution or the like (see Figs. 11(g) and 12(d)).

Finally, the resist pattern 56 is removed by ashing or with a stripping liquid to form the fourth galvanic-type droplet sensor 104 provided with the first electrode 17 that has the first thin wire 12 and the first current collector 15 formed of the first metal-containing material layer having an upper surface capped with the oxide insulating film pattern 54 and the second electrode 18 that has the second thin wire 13 and the second current collector 16 having an upper surface capped with the oxide insulating film pattern 54 as similar to the first electrode 17 and having a core (base layer) formed of the first metal-containing material layer and a sidewall on which the platinum-containing material layer is formed (see Figs. 11(h), 12(e), and 12(e')). Fig. 12(e) is a top view and Fig. 12(e') is a top perspective view showing the central patterns of the first and second electrodes and its surroundings as a height position (a position below a lower surface of the oxide insulating film) (in thickness direction).

In the fourth galvanic-type droplet sensor 104 manufactured in this way, the arrangement of the first thin wire 12 and the second thin wire 13 (that is, the arrangement of the first electrode 17 and the second electrode 18) is determined by the resist pattern 53 formed by single exposure, which prevents variation in spacing between the first thin wire 12 and the second thin wire 13 and prevents degradation of accuracy in droplet detection which is attributed to variation in spacing between the thin wires.

In addition, the second current collector 16 has the same configuration as the second thin wire 13, having the core (base layer) formed of the first metal-containing material layer and including the same material as the first current collector 15 (excluding the oxide insulating film). Accordingly, wires drawn out of the fourth galvanic-type droplet sensor 104 include the same material. For this reason, the fourth galvanic-type droplet sensor 104 manufactured by this method has a preferable structure even from the electrical resistance point of view.

### Examples

### (Example 1)

In Example 1, the first electrode 17 having the first thin wire 12 and the first current collector 15 was used as a first metal-containing material layer composed of Al, and the second electrode 18 having the second thin wire 13 and the second current collector 16 was formed in such a manner that the first metal-containing material layer 13a composed of Al served as a lower layer and the platinum-containing material layer 13b served as an upper layer, and the first thin wire 12 and the second thin wire 13 were arranged in a comb shape, thereby producing the galvanic-type droplet sensor 102 having the second structure to examine its properties.

As a matter of course, the present invention is not limited to this specific aspect. It is noteworthy that the technical scope of the present invention is defined by the scope of claims.

The structure of samples prepared in Example 1 will now be described in detail with reference to Fig. 4(b).

A 6-inch Si wafer formed by sputtering a silica film having a thickness of 100 nm was used as the insulating substrate 11.

An aluminum (Al) layer deposited by electron beam deposition was used as the first thin wire 12. Fifty thin wires were prepared. Each thin wire had a width of 1 µm, a thickness of 150 nm, and a length of 1 mm. Al has electrical resistivity of 2.65 × 10⁻⁸ Ωm, which is as small as about 1/4 of the electrical resistivity of platinum, that is, 1.06 × 10⁻⁷ Ωm. The substrate during the deposition was set at room temperature, and the deposition was performed at a rate of 0.1 to 0.2 nm per second.

As the second thin wire 13, a laminated film having the first metal-containing material layer 13a composed of Al as a lower layer and the platinum (Pt)-containing material layer 13b as an upper layer was used. The Al layer was deposited by electron beam deposition under conditions similar to those of the method for depositing the first thin wire 12. Similarly, the platinum layer was deposited by electron beam deposition on the substrate at room temperature and at a rate of 0.1 to 0.2 nm per second. Fifty thin wires were prepared. Each thin wire had a width of 1 µm, a thickness of 150 nm, and a length of 1 mm. Among the thin wires, the first metal-containing material layer 13a composed of Al was made to have a thickness of 100 nm, and the platinum-containing material layer 13b was made to have a thickness of 50 nm.

Two kinds of samples were produced. In one sample, a designed value of the spacings d₁ and d₂ between the first thin wire 12 and the second thin wire 13 were 0.5 µm (d₁ = d₂ = 0.5 µm), and the other sample had a designed value of 10 µm (d₁ = d₂ = 10 µm).

The prototype galvanic-type droplet sensor 102 was placed in a box having a relative humidity of 100% at room temperature, thereby measuring the sensor response. The sample with a spacing of 0.5 µm between the first thin wire 12 and the second thin wire 13 was measured four times. The minimum current value was 180 pA, the maximum current value was 330 pA, and the average value was 255 pA. Furthermore, both of the samples had a S/N ratio of 100 or more. In addition, sensitivity varied little between the produced samples.

In order to explore the effect of the samples of Example 1, comparative samples were produced in accordance with the samples of Example 1 except that a second thin wire was produced only with a platinum layer. As a result of measuring the sensor response of the comparative samples, one with a spacing of 0.5 µm between thin wires had a current value of 100 pA or less and a S/N ratio of about 10 at a maximum.

### (Example 2)

In Example 2, as an example of forming a platinum-containing material layer by electroplating, a platinum layer was formed on a first metal-containing material layer by platinum (Pt) plating.

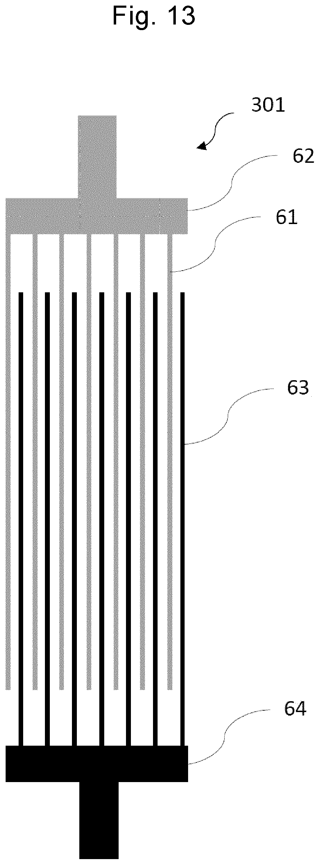

As shown in Fig. 13, a Si substrate provided with a thermal oxide film having a thickness of 500 nm as an insulating substrate was used to prepare a sample 301 in which a first thin wire 61 composed of aluminum (Al), a first current collector 62, a second thin wire 63 composed of gold (Au), and a second current collector 64 were formed. Both the first thin wire 61 and the second thin wire 63 were designed to have a width of 2 µm, and a spacing between the first thin wire 61 and the second thin wire 63 was 5 µm.

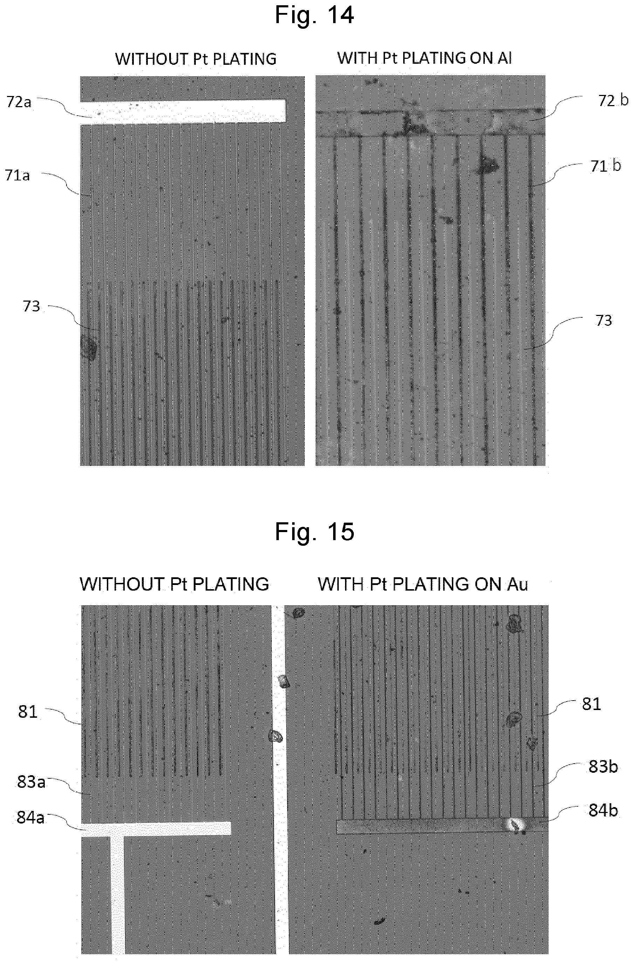

Figs. 14 and 15 respectively show a result of Pt plating performed on the first thin wire 61 and the first current collector 62 of the sample 301 and a result of Pt plating performed on the second thin wire 63 and the second current collector 64. Along with the results, Figs. 14 and 15 each show the sample 301 before Pt plating. Figs. 14 and 15 show optical micrographs obtained by observing an upper surface of each sample. The left side of Figs. 14 and 15 show photographs of the samples without Pt plating, and the right side show photographs of the samples after Pt plating. Since each photograph is an image observed from the upper surface of a sample, among materials included in thin wires and current collectors, what can be observed are those exposed to the upper surface and sidewall. That is to say, the exposed materials are aluminum (71a, 72a, 81), gold (73, 83a, 84a), and platinum (71b, 72b, 83b, 84b). Therefore, structures denoted by the symbol "b" (71b, 72b, 83b, 84b) in Figs. 14 and 15 are thin wires and current collectors having a platinum layer formed by Pt plating.

As a Pt plating solution, an aqueous solution of K₂PtCl₄ (10 g/dm³), boric acid (40 g/dm³), and sodium malonate (0.02 mol/dm³) was used, and Pt plating was performed by applying a current of 2.5 µA for 120 seconds only to the thin wires and the current collectors to be subjected to Pt adhesion (the thin wires and the current collectors on which a platinum layer is to be formed). The temperature was room temperature (25°C).

As a result of the plating, the inventors found that Pt was selectively and symmetrically formed only on the thin wires and the current collectors to which the current was applied. This result indicates that, when a pattern of a first electrode having a first thin wire and a first current collector and a pattern of a second electrode having a second thin wire and a second current collector (patterns of electrodes formed of the first electrode and the second electrode) are formed together, that is, by single lithography, and when a current is applied to either the first electrode or the second electrode for electroplating, it is possible to provide the electrodes with the thin wires having an equal spacing between the first and second thin wires.

### Industrial Applicability

According to the present invention, there is provided a droplet sensor having stable detection properties. Even when the droplet sensor is mass-produced, the present invention enables reduction of manufacturing variation between the elements and enables high detection accuracy and high electrical output of the elements. Furthermore, incorporating this droplet sensor into a condensation detection device provides the condensation detection device with stable detection properties. Even when the condensation detection device is mass-produced, the present invention enables reduction of manufacturing variation between the elements and enables high detection accuracy and high electrical output of the elements.

The droplet sensor and the condensation detection device are of wide application and can be used for, for example, controlling environments, understanding and controlling conditions of indoor condensation or foggy window, monitoring corrosive environments such as bridges, and sensing rain and fog. Having a small size, high accuracy, high sensitivity, and stable droplet detection properties with reduced lot-to-lot variation, the sensor according to the present invention is expected to be used in various situations.

### Reference Signs List

- 1: FIRST THIN WIRE (METAL A)
- 2: SECOND THIN WIRE (METAL B)
- 3: FIRST CURRENT COLLECTOR
- 4: SECOND CURRENT COLLECTOR
- 5: FIRST ELECTRODE
- 6: SECOND ELECTRODE
- 7: INSULATING SUBSTRATE
- 11: INSULATING SUBSTRATE
- 12: FIRST THIN WIRE
- 13: SECOND THIN WIRE
- 13a: FIRST METAL-CONTAINING MATERIAL LAYER
- 13b: PLATINUM-CONTAINING MATERIAL LAYER
- 14: OXIDE INSULATING FILM
- 15: FIRST CURRENT COLLECTOR
- 16: SECOND CURRENT COLLECTOR
- 17: FIRST ELECTRODE
- 18: SECOND ELECTRODE
- 21: PLATINUM-CONTAINING MATERIAL LAYER PATTERN
- 21a: PLATINUM-CONTAINING MATERIAL (Pt) LAYER PATTERN
- 22: FIRST METAL-CONTAINING MATERIAL LAYER PATTERN
- 22a: FIRST METAL-CONTAINING MATERIAL (Al) LAYER
- 23: RESIST PATTERN
- 23a: RESIST PATTERN OF FIRST ELECTRODE
- 23b: RESIST PATTERN OF SECOND ELECTRODE
- 31: FIRST METAL-CONTAINING MATERIAL LAYER PATTERN
- 31a: FIRST METAL-CONTAINING MATERIAL (Al) LAYER
- 32: PLATINUM-CONTAINING MATERIAL LAYER PATTERN
- 32a: PLATINUM-CONTAINING MATERIAL LAYER PATTERN
- 33: RESIST PATTERN
- 33a: RESIST PATTERN OF FIRST ELECTRODE
- 33b: RESIST PATTERN OF SECOND ELECTRODE
- 41: FIRST METAL-CONTAINING MATERIAL LAYER PATTERN
- 41a: FIRST METAL-CONTAINING MATERIAL (Al) LAYER
- 42: PLATINUM-CONTAINING MATERIAL LAYER
- 43: RESIST PATTERN
- 43a: RESIST PATTERN
- 43b: RESIST PATTERN
- 51: FIRST METAL-CONTAINING MATERIAL LAYER PATTERN
- 51a: FIRST METAL-CONTAINING MATERIAL (Al) LAYER
- 53: RESIST PATTERN
- 53a: RESIST PATTERN
- 53b: RESIST PATTERN
- 54: OXIDE INSULATING FILM PATTERN
- 54a: OXIDE INSULATING FILM
- 55: PLATINUM-CONTAINING MATERIAL LAYER
- 55a: PLATINUM-CONTAINING MATERIAL LAYER
- 56: RESIST PATTERN
- 61: FIRST THIN WIRE (Al)
- 62: FIRST CURRENT COLLECTOR (Al)
- 63: SECOND THIN WIRE (Au)
- 64: SECOND CURRENT COLLECTOR (Au)
- 71a: Al THIN WIRE
- 71b: Al THIN WIRE ON WHICH Pt LAYER IS FORMED
- 72a: Al CURRENT COLLECTOR
- 72b: Al CURRENT COLLECTOR ON WHICH Pt LAYER IS FORMED
- 73: Au THIN WIRE
- 81: Al THIN WIRE
- 83a: Au THIN WIRE
- 83b: Au THIN WIRE ON WHICH Pt LAYER IS FORMED
- 84a: Au CURRENT COLLECTOR
- 84b: Au CURRENT COLLECTOR ON WHICH Pt LAYER IS FORMED
- 101: GALVANIC-TYPE DROPLET SENSOR
- 111: INTERMEDIATE
- 102: GALVANIC-TYPE DROPLET SENSOR
- 112: INTERMEDIATE
- 103: GALVANIC-TYPE DROPLET SENSOR
- 113: INTERMEDIATE
- 104: GALVANIC-TYPE DROPLET SENSOR
- 114: INTERMEDIATE
- 201: GALVANIC-TYPE DROPLET SENSOR IN THE RELATED ART
- 202: ELECTRODE
- 202a: PATTERN OF ELECTRODE (THIN WIRE AND CURRENT COLLECTOR)
- 301: SAMPLE

## Claims

1. A droplet sensor comprising:
an insulating substrate;
a first electrode having a first thin wire and a first current collector; and
a second electrode having a second thin wire and a second current collector,
the first electrode and the second electrode being disposed on the insulating substrate, and the first thin wire and the second thin wire being alternately disposed in juxtaposition with each other on the insulating substrate, and
the droplet sensor being configured to sense a galvanic current flowing between the first thin wire and the second thin wire through a conductive droplet, wherein
the first thin wire and the first current collector are formed of a first metal-containing material layer having a lower electrical resistivity than platinum,
the second thin wire is a composite film of the first metal-containing material layer and a platinum-containing material layer composed of platinum or a platinum alloy, and the second current collector includes the first metal-containing material layer, and
the platinum-containing material layer has at least a part of a surface exposed to the outside.

2. The droplet sensor as claimed in claim 1, wherein the second thin wire is a laminated film of the first metal-containing material layer and the platinum-containing material layer.

3. The droplet sensor as claimed in claim 1, wherein the second thin wire has a core formed of the first metal-containing material layer, and the platinum-containing material layer is formed at least on a part of a sidewall of the core.

4. The droplet sensor as claimed in claim 1, wherein the second thin wire has a core formed of the first metal-containing material layer, and the platinum-containing material layer is formed to cover the core.

5. The droplet sensor as claimed in any one of claims 1 to 4, wherein the spacing between the first thin wire and the second thin wire is constant.

6. The droplet sensor as claimed in any one of claims 1 to 5, wherein the first metal-containing material layer is composed of one or more metals selected from the group consisting of aluminum (Al), magnesium (Mg), zinc (Zn), iron (Fe), cobalt (Co), nickel (Ni), molybdenum (Mo), copper (Cu), silver (Ag), gold (Au), and tungsten (W) or an alloy containing one or more metals selected from the group.

7. The droplet sensor as claimed in any one of claims 1 to 6, wherein the platinum-containing material layer has a thickness of 5 nm or more and 150 nm or less.

8. The droplet sensor as claimed in any one of claims 1 to 7, wherein the spacing between the first thin wire and the second thin wire is in a range of 100 nm or more and 100 µm or less.

9. The droplet sensor as claimed in claim 8, wherein the spacing between the first thin wire and the second thin wire is in a range of 100 nm or more and 10 µm or less.

10. A condensation detection device equipped with the droplet sensor as claimed in any one of claims 1 to 9.

11. A method for manufacturing a droplet sensor or a condensation detection device, the method comprising:
producing an intermediate in which a pattern of a platinum-containing material layer composed of platinum or a platinum alloy is formed on an insulating substrate;
forming a first metal-containing material layer including a metal having a lower electrical resistivity than platinum on the intermediate; and
performing processes including single lithography to form a first electrode and a second electrode on the insulating substrate, the first electrode having a first thin wire formed of the first metal-containing material layer and a first current collector formed of the first metal-containing material layer, the second electrode having a second thin wire that is a composite film of the platinum-containing material layer and the first metal-containing material layer and a second current collector including the first metal-containing material layer, and the first thin wire and the second thin wire being alternately disposed in juxtaposition with each other on the insulating substrate.

12. A method for manufacturing a droplet sensor or a condensation detection device, the method comprising:
forming a first metal-containing material layer including a metal having a lower electrical resistivity than platinum on an insulating substrate;
producing an intermediate in which a pattern of a laminated body having a platinum-containing material layer composed of platinum or a platinum alloy is laminated on the first metal-containing material layer; and
performing processes including single lithography to form a first electrode and a second electrode on the insulating substrate, the first electrode having a first thin wire formed of the first metal-containing material layer and a first current collector formed of the first metal-containing material layer, the second electrode having a second thin wire that is a composite film of the platinum-containing material layer and the first metal-containing material layer and a second current collector including the first metal-containing material layer, and the first thin wire and the second thin wire being alternately disposed in juxtaposition with each other on the insulating substrate.

13. A method for manufacturing a droplet sensor or a condensation detection device in which a first electrode and a second electrode are formed on an insulating substrate, the first electrode having a first thin wire formed of a first metal-containing material layer including a metal having a lower electrical resistivity than platinum and a first current collector formed of the first metal-containing material layer, the second electrode having a second thin wire that is a composite film of the first metal-containing material layer and a platinum-containing material layer composed of platinum or a platinum alloy and a second current collector including the first metal-containing material layer, and the first thin wire and the second thin wire being alternately disposed in juxtaposition with each other on the insulating substrate,
the method comprising:
producing an intermediate on the insulating substrate by forming the first electrode and a temporary electrode that is formed of the first metal-containing material layer and has a pattern of the second electrode or a pattern obtained by lessening the pattern of the second electrode; and
forming the second electrode by forming the platinum-containing material layer on at least a surface of a thin wire of the temporary electrode of the intermediate by electroplating.

14. The method for manufacturing a droplet sensor or a condensation detection device as claimed in claim 13, wherein the first electrode and the temporary electrode are formed by single lift-off.

15. The method for manufacturing a droplet sensor or a condensation detection device as claimed in claim 13, wherein the first electrode and the temporary electrode are formed by single deposition, single lithography, and etching of the first metal-containing material on the insulating substrate.

16. A method for manufacturing a droplet sensor or a condensation detection device in which a first electrode and a second electrode are formed on an insulating substrate, the first electrode having a first thin wire formed of a first metal-containing material layer including a metal having a lower electrical resistivity than platinum and a first current collector formed of the first metal-containing material layer, the second electrode having a second thin wire that is a composite film of the first metal-containing material layer and a platinum-containing material layer composed of platinum or a platinum alloy and a second current collector including the first metal-containing material layer, and the first thin wire and the second thin wire being alternately disposed in juxtaposition with each other on the insulating substrate,
the method comprising:
forming the first metal-containing material layer and an oxide insulating film in sequence on the insulating substrate;
producing an intermediate on the insulating substrate by performing processes including single lithography to form the first electrode and a temporary electrode having a pattern of the second electrode or a pattern obtained by lessening the pattern of the second electrode;
allowing a platinum-containing material to adhere to the intermediate to form a platinum-containing material layer;
performing anisotropic etching to form the platinum-containing material layer only on a sidewall of the first thin wire of the first electrode and to form the second electrode having the platinum-containing material layer only on a sidewall of at least a thin wire of the temporary electrode;
forming a resist pattern obtained by broadening the pattern of the second electrode and performing etching to remove the platinum-containing material layer in a part not protected by the resist pattern; and
removing the resist pattern.

17. The method for manufacturing a droplet sensor or a condensation detection device as claimed in claim 16, wherein the oxide insulating film is composed of an oxide containing one or more substances selected from the group consisting of yttrium (Y), aluminum, silicon (Si), and cerium (Ce).

18. The method for manufacturing a droplet sensor or a condensation detection device as claimed in any one of claims 11 to 17, wherein the first metal-containing material layer is composed of one or more metals selected from the group consisting of aluminum, magnesium, zinc, iron, cobalt, nickel, molybdenum, copper, silver, gold, and tungsten or an alloy containing one or more metals selected from the group.

19. The method for manufacturing a droplet sensor or a condensation detection device as claimed in any one of claims 11 to 18, wherein the platinum-containing material layer has a thickness of 5 nm or more and 150 nm or less.

20. A method for manufacturing a droplet sensor or a condensation detection device as claimed in any one of claims 11 to 19, wherein the spacing between the first thin wire and the second thin wire is in a range of 100 nm or more and 100 µm or less.
